Europäisches Patentamt

(19) European Patent Office

Office européen des brevets

(11) Publication number: **0 129 294**
**A1**

(12) # EUROPEAN PATENT APPLICATION

(21) Application number: **84200855.9**

(22) Date of filing: **13.06.84**

(51) Int. Cl.³: **H 05 K 7/10**

(30) Priority: **14.06.83 US 504260**

(43) Date of publication of application:
**27.12.84 Bulletin 84/52**

(84) Designated Contracting States:
**DE FR GB**

(71) Applicant: **AUGAT INC.**
**89 Forbes Boulevard**
**Mansfield Massachusetts 02048(US)**

(72) Inventor: **Petersen, Richard W.**
**Landisville Road**
**Doylestown Pennsylvania 18901(US)**

(72) Inventor: **Pierini, John M.**
**49 Mt. Hope Street**
**No. Attleboro Massachusetts 02760(US)**

(74) Representative: **Urbanus, Henricus Maria, Ir. et al,**
**c/o Vereenigde Octrooibureaux Nieuwe Parklaan 107**
**NL-2587 BP 's-Gravenhage(NL)**

(54) PC board-transparent quiet connector for integrated circuits.

(57) A connector for an integrated circuit or other electronic component includes means for mounting and electrically connecting a decoupling capacitor (64) entirely within the housing of the connector to provide an interconnection board-transparent quiet connector. The capacitor is mounted within a central slot (18) provided therefor in the housing. Clips having insulation displacing (IDC) slots (60) and integrally formed cantilever beams (68) are mounted within slots provided therefor in the housing. Internally to the housing, the IDC slots electrically contact the leads of the capacitor, and the cantilever beams electrically contact preselected ones of the signal contacts of the connector. When the quiet connector is mounted to a printed circuit (PC) or other interconnection board, its leads are transparent to the board requiring neither special drilling thereinto nor other specialized handling.

EP 0 129 294 A1

./...

FIG. 1

Title: PC Board-Transparent Quiet Connector for Integrated Circuits.

## FIELD OF THE INVENTION

This invention is drawn to the field of electrical interconnection devices, and more particularly, to an interconnection board-transparent quiet connector.

## BACKGROUND OF THE INVENTION

Miniature, integrated circuits are commonly mounted into DIP electrical connectors and other socketed bodies. The sockets of the connectors typically have a female portion adapted to removably receive the leads of the integrated circuits, and an extending male portion adapted to be inserted in, and soldered to, either printed circuit or other interconnection boards. So-called quiet connectors are employed whenever it is desirable to suppress undesirable voltage spikes and other transient signals. The heretofore known quiet connectors for integrated circuits have a decoupling capacitor mounted within a recessed slot provided therefor in the housing of the connector. The leads from the capacitor are accepted in clips that are bottom-loaded into the housing of the quiet connector. The clips each have an elongated, depending electrode that extends below the housing and butts preselected ones of the extending male portions of the sockets of the connectors in a parallel and contiguous manner. Among other disadvantages, the combined thickness dimension of the parallel and contiguous butted leads requires the special provision of over-sized lead receiving holes therefor in PC and other interconnection boards.

## SUMMARY OF THE INVENTION

The novel quiet connector for integrated circuits and other electronic components of the present invention overcomes these and other disadvantages and neither requires external, butted leads nor over-sized holes therefor in PC or other interconnection boards. The quiet connector for integrated circuits of the present invention contemplates mounting a decoupling capacitor entirely within a connector housing to render it transparent to an interconnection board. In preferred embodiment, the invention includes a housing having a plurality of signal contact receving openings therethrough arranged in lateral rows adjacent the sides of the housing, a longitudinally extending central decoupling capacitor receiving recess, first and second transversely extending decoupling capacitor clip receiving slots in communication with respective ends of the longitudinally extending central decoupling capacitor receiving recess, and first and second walls defining intrahousing chambers individually in communication with diagonally opposed ones of the signal-contact receiving openings. A decoupling capacitor having leads is mounted within the decoupling capacitor-receiving recess. First and second insulation-displacing decoupling capacitor clips are top-mounted within, and frictionally engaged by, corresponding ones of the transversely extending decoupling capacitor receiving slots. A plurality of signal contacts are individually mounted from the bottom into, and frictionally held by, corresponding ones of the signal-contact receiving openings.

The decoupling capacitor clips each include resilient, integrally formed, depending cantilever leads that abut, and electrically contact, the outer walls of the signal contacts mounted within corresponding ones of the diagonally opposed signal contact receiving openings via the first and second intrahousing chambers. First and second flanges having a plurality of selectively inclined surfaces adjacent the top mouths of the signal-contact receiving openings are provided on the top surface of the housing to facilitate lead plugability thereinto. The periphery of the top mouths of the signal contact receiving openings are provided with inclined surfaces to further facilitate lead plugability thereinto.

## DETAILED DESCRIPTION OF THE DRAWINGS

Other advantages and features of the present invention will become apparent as the invention becomes better understood by referring to the following exemplary and non-limiting detailed description of the preferred embodiment, and to the drawings, wherein:

Fig. 1 is an exploded, perspective view illustrating the interconnection board transparent quiet connector for integrated circuits of the present invention;

Fig. 2 is a fragmentary and broken away perspective view illustrating the bottom of the interconnection board-transparent quiet connector for integrated circuits of the present invention;

Fig. 3 is a fragmentary top plan view illustrating the interconnection board-transparent quiet connector for integrated circuits of the present invention;

Fig. 4 is a sectional view along the line 4-4 of Fig. 3;

Fig. 5 is a sectional view along the line 5-5 of Fig. 3;

Fig. 6 is a fragmentary and broken away perspective view illustrating the end of the interconnection board-transparent quiet connector for integrated circuits of the present invention; and

Fig. 7 is a sectional view along the line 7-7 of Fig. 6.

## DETAILED DESCRIPTION OF THE PREFERRED EMBODIMENT

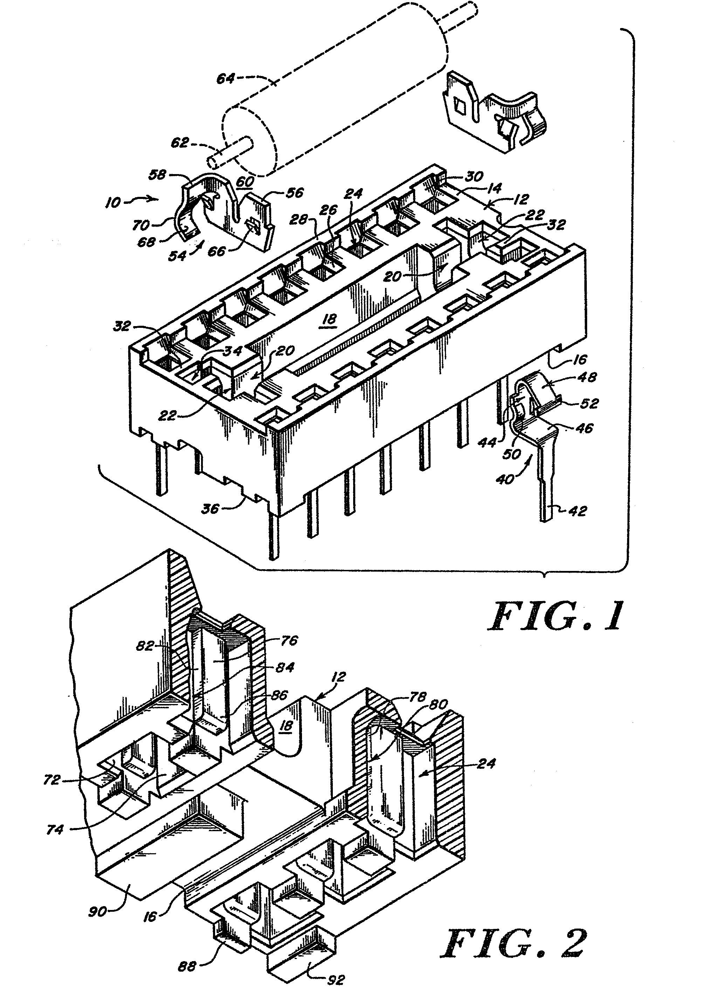

Referring now to Fig. 1, generally designated at 10 is an exploded perspective view illustrating the interconnection board-transparent quiet connector for integrated circuits of the present invention. The connector 10 includes a housing generally designated 12 having a top surface 14 and a bottom surface 16. The housing 12 is provided with a central, longitudinally extending decoupling capacitor receiving slot generally designated 18 terminating on its ends in lead receiving necks generally designated 20. The housing 12 also has "L"-shaped transversely extending decoupling capacitor clip receiving slots generally designated 22 individually in communication with corresponding ones of the necks 20. A plurality of signal contact receiving openings generally designated 24 to be described are provided through the housing. The openings 24 extend from the top surface 14 to the bottom surface 16 and are arranged in spaced-apart relation in lateral rows adjacent the sides of the housing. The openings 24 are individually provided with inclined surfaces 26 peripherally around the top mouths thereof. Upstanding flanges 27 are provided on the top surface 14 of the housing 12 adjacent the sides. The flanges 27 have a plurality of spaced-apart inclined surfaces 30 individually formed adjacent corresponding ones of the openings 24. The inclined surfaces 26, 30 facilitate lead plugability into the openings 24. The longitudinally extending portions of the "L"-shaped decoupling capacitor clip receiving slots 22 are respectively adjacent to diagonally opposed ones of the openings 26, preferably along the largest diagonal. Walls 32 provided on the top surface 14 of the housing 12 separate the bases of the "L"-shaped slots 22 from corresponding ones of the diagonally opposed opening 26 forming thereunder first and second intrahousing interconnection chambers generally designated 34 to be described. A plurality of upstanding stand-off tabs 36 are provided in spaced-apart relation in lateral rows on the bottom surface 16 of the housing 12.

A plurality of signal contacts generally designated 40 are individually inserted from the bottom into corresponding ones of the openings 24 provided therefor in the housing 12. The signal contacts 40 each include a depending electrode tail 42, an upstanding neck 44 spaced from the electrode tail 42 via a generally horizontal portion 46, and a resilient, cantilever beam head 48 formed at the top of the neck 44. The dimensions of the electrode tails 42 are selected to conform to standard interconnection board openings, and are received therein in a manner not requiring oversized holes or specialized handling. Bights 50 are provided on the neck 44 in spaced-apart relation which abut and frictionally engage walls defining a neck-receiving channel to be described provided therefor in each of the openings 24. The cantilever beams 48 each terminate in a generally "T"-shaped end portion 52 that electrically contacts and frictionally engages a lead from an integrated circuit, not shown. Each of the signal contacts 40 preferably are integrally formed from any suitable electrically conductive material such as metal.

First and second decoupling capacitor lead receiving clips generally designated 54 are mounted from the top into, and frictionally engaged by, corresponding ones of the "L"-shaped clip receiving slots 22 in a manner to be described. The clips 54 include an upstanding body portion 56. A generally perpendicular arm 58 is integrally formed with the body 56. The body 56 is provided with a central, insulation displacing slot (IDC) generally designated 60 that is adapted to frictionally receive, and electrically contact, leads 62 of a decoupling capacitor 64, shown dashed. Spaced-apart barbs 66 are provided on the body 56. The arms 58 include depending resilient cantilever beams 68. The beams 68 have laterally outwardly extending bights 70 that abut and electrically contact the confronting walls of the upstanding necks 44 of the signal contacts slidably mounted in the diagonally-opposed openings 24 via corresponding ones of the chambers 34 to be described.

Referring now to Fig. 2, each of the signal contact receiving openings 24 are defined by confronting end walls 72, and confronting side walls 74. Opposed, half walls 76 are formed on the end walls 72 of each of the openings 24. The half walls 76 have a side wall 78 spaced from the confronting side wall 74 of the openings 24 defining a neck receiving channel generally designated 80. Each of the half walls 74 also have a side wall 82 spaced from the confronting side wall 76 of the openings 24 defining a signal contact head-receiving channel generally designated 84. Each of the half walls 76 have a wall 86 that, with the corresponding wall 86 of the opposed half wall 76 in each of the openings 24, defines a signal contact head receiving slot. Each of the signal contacts 40 (Fig. 1) is inserted in corresponding ones of the openings 24 such that the necks 44 (Fig. 1) thereof are received in the channels 80 which are so dimensioned that the bights 50 (Fig. 1) abut and are frictionally engaged between the walls 78 of the half walls 76 and the confronting ones of the side walls 74 of the openings 24. The heads 48 of the signal contacts 40 (Fig. 1) are received in corresponding ones of the head-receiving channels 84. The leads, not shown, extending from miniature, integrated circuit and other electronic circuit devices are frictionally engaged between the outer surface of the "T"-shaped ends 52 of the heads 48 of the signal contacts 40 (Fig. 1) and the confronting surfaces of the walls 74 of each of the openings 24. A plurality of stand-off tabs 88 are provided adjacent the bottom mouths of each of the openings 24 in spaced-apart relation laterally in a row extending along the sides of the housing 12. Stand-off tabs 90 are also centrally provided on the bottom surface 16. Stand-off tabs 92 are provided adjacent to the sides of the housing 12. The signal contacts 40 (Fig. 1) are individually slidably mounted in corresponding ones of the above-described openings 24. The inside walls 74 of the diagonally opposed ones of the openings 24 are removed defining first and second intrahousing chambers 34 (Fig. 1) which expose the walls of the necks 44 of the signal contacts 40 (Fig. 1) mounted therein.

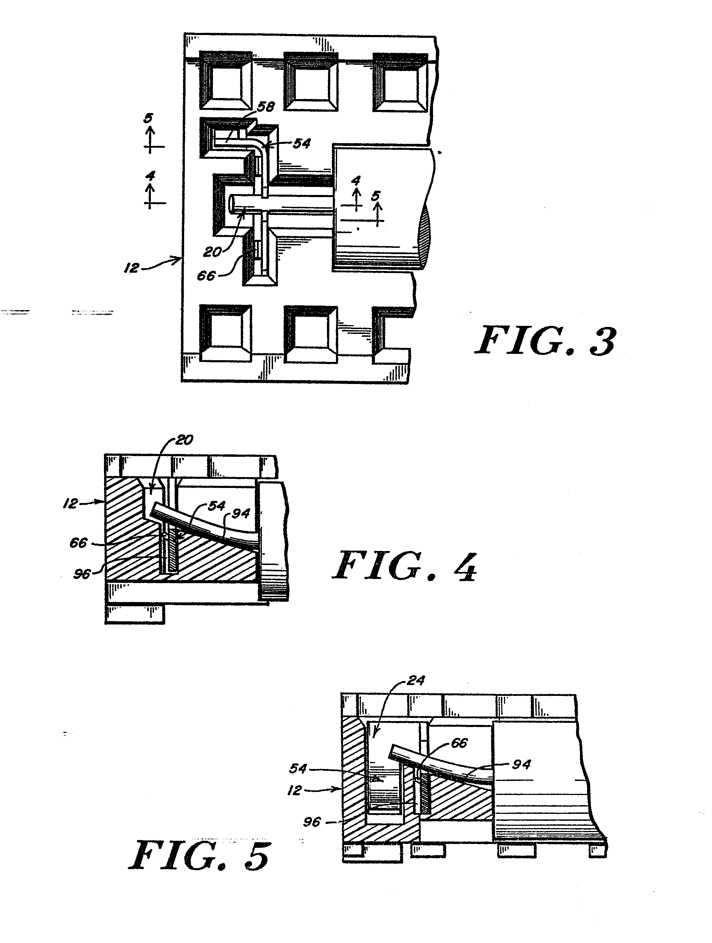

As shown in Figs. 3 through 5, the bottom wall 94 of each of the decoupling capacitor lead receiving slots 20 is preferably tapered to provide an inclined abutment surface upon which each of the leads 62 can rest. The barbs 66 formed on the base 56 of the decoupling capacitor clips 54 are inclined upwardly and to the side and abut the confronting walls of the decoupling capacitor receiving slots 22 preventing their removal therefrom after initial insertion through the top of the housing.

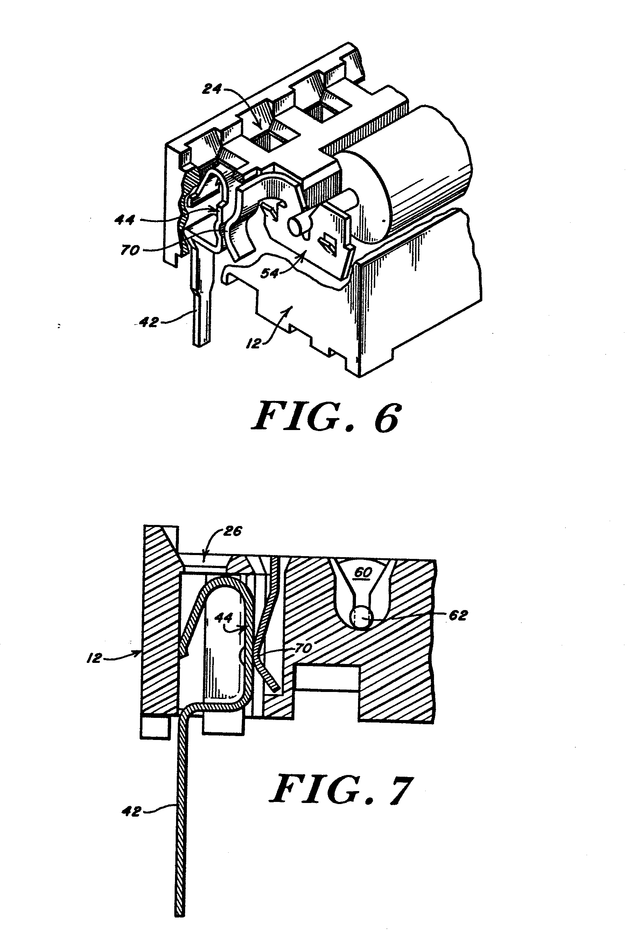

As shown in Figs. 6 and 7, the capacitor 64 is mounted in the housing 12 entirely within the longitudinally extending capacitor receiving slot 18 provided therefor centrally in the housing 12. The capacitor leads 62 are received in corresponding ones of the central, insulation displacing slots 60 provided therefor in the decoupling capacitor clips 54. The arms 58 of the clips 54 extend in the chambers 34 within the housing 12 and the bights 70 thereof abut, and electrically contact, the confronting surface of the necks 44 of the signal contacts 40 slidably mounted in the diagonally opposed openings 24. The signal contacts 70 in the diagonally opposed openings 24 are retained by the half walls 76, and the resiliency provided by the arms 58 mechanically contact and electrical interconnect the necks 44 with the bights 70. The quiet connector for integrated circuits of the present invention may in this manner be readily inserted into standardized interconnection board holes without requiring special drilling, thereby rendering the quiet connector transparent to the PC or other interconnection board, not shown.

It will be appreciated that many modifications of the presently disclosed invention will be readily apparent to those skilled in the art without departing from the scope of the present claims.

C L A I M S

1.     An interconnection board-transparent quiet connector, comprising:

a housing having a decoupling capacitor receiving slot, first and second decoupling capacitor clip receiving slots in communication with respective ends of said decoupling capacitor receiving slot, a plurality of spaced-apart signal contact receiving slots arranged in rows laterally adjacent the sides of the housing, and first and second intrahousing interconnection chambers formed between preselected ones of said signal contact receiving openings and corresponding ones of said decoupling capacitor clip receiving slots;

a plurality of signal contacts slidably mounted in, and frictionally engaged by, corresponding ones of said signal contact receiving openings; and

first and second decoupling capacitor lead receiving clips slideably mounted in, and frictionally engaged by, corresponding ones of said decoupling capacitor clip receiving slots, each of said decoupling capacitor clips having an arm that mechanically contacts, and electrically connects with, corresponding ones of said signal contacts slidably mounted in said preselected ones of said signal contact openings via corresponding ones of said intrahousing interconnection chambers.

2.     The quiet connector of claim 1, wherein said decoupling capacitor lead receiving clips include a base having a central, insulation displacing slot adapted to receive the leads from said decoupling capacitor, and a depending, resilient, cantilever beam formed on said arm.

3.     The quiet connector of claim 2, wherein said signal contacts each include a depending electrode tail and an upstanding neck, and wherein said depending resilient, cantilevered beam mechanically contacts, and electrically connects, said upstanding neck portion of said signal contacts slidably mounted within said preselected ones of said signal contact openings.

4.     The quiet connector of claim 3, wherein said preselected ones of said signal contact openings are diagonally opposed.

5.     The quiet connector of claim 1, further including upstanding flanges formed adjacent the sides of said housing on the top surface thereof having inclined surfaces adjacent the top mouths of said signal contact receiving openings.

6.     The quiet connector of claim 3, wherein said cantilever beam of said decoupling capacitor clips include a bight that contacts said necks.

7.     The quiet connector of claim 1, further including a decoupling capacitor mounted in said decoupling capacitor receiving slot.

8.     A connector for an integrated circuit, comprising:
        a housing having a plurality of signal contacts, each having an internal portion and an external portion;
        a capacitor having leads mounted entirely within said housing; and
        means mounted entirely within said housing for electrically connecting said leads of said capacitor to the internal portions of preselected ones of said signal contacts.

9. The invention of claim 8, wherein said housing has an elongated slot, and wherein said capacitor is slidably mounted in said slot.

10. The invention of claim 9, wherein said means includes first and second capacitor lead receiving clips mounted in first and second clip-receiving slots provided therefor in said housing.

11. The invention of claim 10, wherein said housing has first and second intrahousing interconnection chambers, and wherein said first and second clips mechanically contact and electrically connect the corresponding internal portions of said preselected ones of said signal contacts in said first and said second intrahousing intercommunication chambers.

12. The invention of claim 11, wherein said clips each have a cantilever beam that mechanically contacts said internal portions.

13. The invention of claim 12, wherein said cantilever beams each have a bight that mechanically contacts said internal portions.

14. The invention of claim 10, wherein said clips each have an insulation-displacing slot provided therein for receiving corresponding ones of said leads.

*FIG. 1*

*FIG. 2*

FIG. 3

FIG. 4

FIG. 5

**FIG. 6**

**FIG. 7**

## European Patent Office

**EUROPEAN SEARCH REPORT**

### DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X | US-A-4 326 765  (BRANCALEONE)<br><br>* column 1, lines 39-59; column 4, lines 49-61; figures 1,4,5,7,8 * | 1,5-9, 12,13 | H 05 K  7/10 |
| P,X | US-A-4 428 633  (LUNDERGAN)<br><br>* column 2, lines 56-64; column 3, lines 3-9, 22-25; column 4, lines 19-26; figures 1,5 * | 1-5,7-12,14 | |
| A | EP-A-0 063 023  (AKZONA INC.)<br>* page 3, lines 24-35; page 4, lines 1-3, 10-26; figures 1,4 * | 1,7,8 | |

|  | TECHNICAL FIELDS SEARCHED (Int. Cl. 3) |
|---|---|
|  | H 05 K  7/00<br>H 01 R  13/00<br>H 01 R  23/00 |

The present search report has been drawn up for all claims

| Place of search | Date of completion of the search | Examiner |
|---|---|---|
| THE HAGUE | 20-09-1984 | GEOGHEGAN C.H.B. |